# EUROPEAN PATENT APPLICATION

(11) **EP 1 614 774 A1**
(43) Date of publication of application: **11.01.2006**
(21) Application number: 04724388.6
(22) Date of filing: 30.03.2004
(51) Int. Cl.: C30B 15/20, C30B 29/06

(54) **PROCESS FOR PRODUCING SINGLE CRYSTAL**

(30) Priority: 14.04.2003 JP 2003108787
(71) Applicant: Shin-Etsu Handotai Co., Ltd, Tokyo 100-0005 (JP)
(72) Inventor: HOSHI, Ryoji, Nidhigo-mura, Nishishirakawa-gun (JP); SONOKAWA, Susumu, Nidhigo-mura, Nishishirakawa-gun (JP)
(74) Representative: Cooper, John
(86) International application number: PCT/JP2004/004551
(87) International publication number: WO 2004/092455

(57) **Abstract**

A method of producing a single crystal according to Czochralski method comprising the steps of, charging polycrystalline material into a crucible, heating and melting the polycrystalline material by a heater disposed so as to surround the crucible, immersing a seed crystal into the material melt and then pulling the seed crystal to grow a single crystal, wherein in the case of growing a single crystal of which resistivity is controlled by doping with boron, the highest temperature of the crucible is controlled to be 1600°C or less to grow the single crystal. Thereby, there is provided a method of producing a single crystal in which generation of dislocation is prevented when a single crystal having high gettering property and doped with boron is produced, and thus the single crystal can be produced at high productivity and at low cost.

## Description

### Technical Field

The present invention relates to a method for producing a single crystal, more particularly, to a method for producing a silicon single crystal in which boron is doped as a dopant.

### Background Art

Czochralski method (CZ method) and Floating Zone method (FZ method) is conventionally known as a method for producing a single crystal like a silicon single crystal.

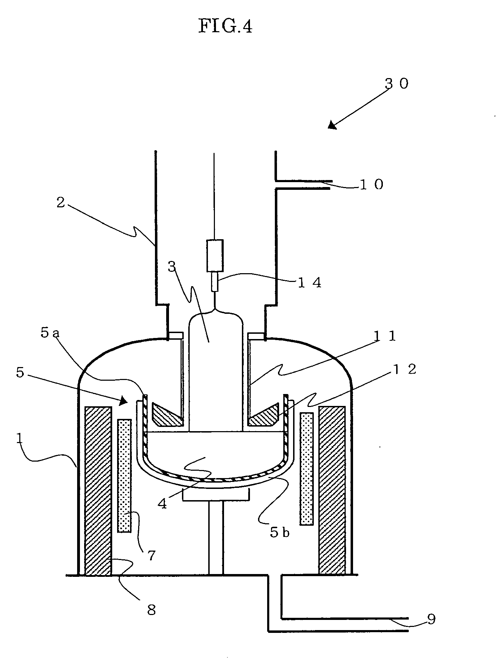

In order to produce a silicon single crystal by CZ method, an apparatus 30 for producing a single crystal as shown in Fig. 4 is used. Polycrystalline silicon is charged as a raw material into a crucible 5, and the polycrystalline silicon is heated and melted by a heater 7 disposed so as to surround the crucible 5. Next, after a seed crystal 14 is immersed into a material melt 4, the seed crystal is gradually pulled with being rotated to grow a single crystal 3. In recent years, a single crystal has a larger size, and it has become common to use so-called MCZ method in which a single crystal 3 is grown with applying a magnetic field to the melt 4.

The grown silicon single crystal is subsequently subjected to processes of slicing, chamfering, polishing and so on to obtain a mirror-surface wafer. Moreover, there is a case that an epitaxial layer is further formed on the mirror-surface wafer. In such an epitaxial wafer when heavy metal impurities exist on a silicon wafer to be a substrate, characteristic failure of a semiconductor device arises. Thus it is necessary to reduce heavy metal impurities as much as possible.

For that reason, significance of gettering technique has more and more increased as one of the techniques reducing heavy metal impurities.
It has become common to use a P-type silicon wafer having high gettering effect and low resistivity (e.g., 0.1 Ω · cm or less) as a substrate for an epitaxial wafer. Because an epitaxial wafer using a substrate of such a single crystal with low resistivity is advantageous in regard to problems of latch up and gettering, the wafer has drawn attention as a wafer of high quality.

Furthermore, it has also become common that nitrogen is doped for the purpose of increasing BMD, controlling a size of Grown-in defect and so on (for example, see Japanese Patent Laid-open (Kokai) No. 2000-44389 and Japanese Patent Laid-open (Kokai) No. 2003-2786).

Therefore, in recent years, it has become common to grow by MCZ method (or CZ method) a P-type (boron-doped) silicon single crystal with low resistivity which is doped with nitrogen in view of problem of gettering and so on, and has a diameter of 200mm or more, particularly a large diameter of 300mm.

In this connection, when a single crystal is grown by CZ method, it often happens that dislocation is generated during growth and the crystal turns into polycrystal. If dislocation is generated, slip dislocation is propagated not only to the portion that is subsequently grown but also to the portion that was grown before, and a single crystal, that is, value as a product is lost. For this reason, conventionally when dislocation is generated, the grown single crystal is melted again (remelted) and a single crystal is grown again (regrown). However, because conducting such remelting and regrowing over and over again leads to reduction of productivity, it is preferable to prevent generation of dislocation.

### Disclosure of the Invention

Then, the present inventors performed investigations in regard to generation of dislocation. Consequently, it has been found that, when a single crystal doped with boron, particularly a single crystal with low resistivity (e.g., 0.1 Ω · cm or less) is grown, generation of dislocation frequently occurs in comparison to a crystal with normal resistivity, the number of times of melting a single crystal in which dislocation was generated and growing a crystal again is increased, and thus it leads to considerable decrease of productivity.

The present invention was accomplished in view of the aforementioned problems. An object of the present invention is to provide a method of producing a single crystal that, when a single crystal having high gettering ability and doped with boron is produced, generation of dislocation is inhibited and the crystal can be produced with high productivity and at low cost.

In order to achieve the aforementioned object, according to the present invention, there is provided a method of producing a single crystal according to Czochralski method comprising the steps of, charging polycrystalline material into a crucible, heating and melting the polycrystalline material by a heater disposed so as to surround the crucible, immersing a seed crystal into the material melt and then pulling the seed crystal to grow a single crystal, wherein in the case of growing a single crystal of which resistivity is controlled by doping with boron, the highest temperature of the crucible is controlled to be 1600°C or less to grow the single crystal.

As described later, it has been found by analyses of the present inventors that one of the causes of generating dislocation when a single crystal is produced by CZ method is boron nitride (BN) formed at a temperature of approximately 1500°C or more. Then, in the case of growing a single crystal of which resistivity is controlled by doping with boron, if the highest temperature of a crucible is controlled to be 1600°C or less to grow the single crystal, formation of boron nitride is inhibited and generation of dislocation due to boron nitride is prevented. Therefore, productivity can be improved and a single crystal having high gettering ability and doped with boron can be produced at low cost.

In this case, it is preferable that the single crystal doped with boron is grown so that the resistivity of the single crystal to be grown is 0.1 Ω cm or less.

If resistivity of a single crystal to be grown is more than 0.1Ω cm, there is a case that it might cause little problem because a doping amount of boron is relatively small. However, because concentration of boron is considerably high in a single crystal with low resistivity of 0.1 Ω cm or less, even an existence of a little nitrogen easily leads to generation of dislocation due to BN. Accordingly, the present invention has especially beneficial effect on growing such a single crystal with low resistivity.

On the other hand, it is preferable that the single crystal doped with boron is grown so that the resistivity of the single crystal to be grown is 0.001 Ω cm or more.

In the case of growing a single crystal with a resistivity less than 0.001 Ω cm, a doping amount of boron becomes extremely large, and it becomes difficult to be crystallized as a single crystal. Accordingly, it is preferable that the single crystal doped with boron is grown so that the resistivity of the single crystal is 0.001 Ω cm or more.

Moreover, it is preferable that the single crystal doped with nitrogen is grown so that concentration of nitrogen in the single crystal to be grown is from 1 x 10¹⁰ /cm³ to 5 x 10¹⁵ /cm³.

If a single crystal is grown by doping with nitrogen so that concentration of nitrogen is within the above-mentioned range, crystallization of single crystal isn't adversely affected, BMD and Grown-in defect are sufficiently controlled, and a single crystal having even higher gettering ability can be certainly produced. Furthermore, in the case of growing a single crystal doped with both boron and nitrogen, boron nitride is very likely to be formed when concentration of nitrogen is within the above-mentioned range even if its resistivity is a high resistivity of 1000Ω cm of which boron is doped at low concentration. However, formation of boron nitride is inhibited by controlling the highest temperature of a crucible to be 1600°C or less, and thus the present invention particularly has beneficial effect.

It is preferable that a silicon single crystal is grown as the single crystal.

A silicon single crystal is in high demand. A P-type silicon single crystal with high quality can be produced at lower cost when the present invention is applied to the production.

Furthermore, when the single crystal is grown, it is preferable that a magnetic field of at least 300 gauss or more is applied to the material melt to grow the single crystal.

In recent years, it has become common to produce a single crystal by MCZ method. When a magnetic field is applied with an intensity of 300 gauss or more, an effect of suppressing a convection of a melt is increased and temperature gradient tends to be generated. Therefore, temperature of the melt tends to be high. However, if a single crystal is grown with controlling the highest temperature of a crucible to be 1600°C or less, the temperature of a melt is kept low and formation of boron nitride is inhibited. Accordingly, generation of dislocation due to boron nitride is prevented and a single crystal with a large diameter and high gettering ability can be produced at high productivity.

It is preferable that a single crystal with a diameter of 200mm or more is grown as the single crystal.

When a single crystal with a large diameter of 200mm or more is grown, a large crucible is used. In this case, a distance between the crucible and the crystal is large, and thus the crucible is heated to a high temperature to grow a single crystal with keeping molten state of a melt in the crucible. Therefore, boron nitride comes to be easily generated. However, even in the case of growing such a single crystal with a large diameter, formation of boron nitride is inhibited by performing growth with controlling the highest temperature of a crucible to be 1600°C or less, and thus a single crystal with a large diameter can be produced at high productivity.

As mentioned above, according to the present invention, in the case of growing a single crystal of which resistivity is adjusted by doping with boron by Czochralski method, the highest temperature of a crucible is controlled to be 1600°C or less to grow the single crystal. By controlling the temperature of the crucible to be 1600°C or less, a temperature of a material melt in the crucible is kept low, and thus formation of boron nitride can be inhibited. Accordingly, frequency of generation of dislocation in a single crystal due to boron nitride is considerably reduced. Thus, a P-type single crystal having a high gettering ability can be produced at high productivity. As a result, decrease of production cost can be achieved.

### Brief Explanation of the Drawings

Fig. 1 is a schematic view showing an example of an apparatus for producing a single crystal that can be used in the present invention.
Fig. 2 is a schematic view showing another example of an apparatus for producing a single crystal that can be used in the present invention.
Fig. 3 is a schematic view showing a further example of an apparatus for producing a single crystal that can be used in the present invention.
Fig. 4 is a schematic view showing an example of a conventional apparatus for producing a single crystal.
Fig. 5 is a graph in which productivity of examples and a comparative example are compared.
Fig. 6 is a graph showing the relation between the highest temperature of a crucible and ratio of productivity.

### Best Mode for Carrying out the Invention

Hereinafter, the present invention will be explained in more detail.

The present inventors made investigation into various situations of generating dislocation by using various analysis methods (IR, X-ray diffraction, Raman spectroscopy, fluorescent X-ray and the like). Consequently, one of causes of generating dislocation of a boron-doped single crystal with low resistivity could be identified as boron nitride (BN) formed as a result of reaction of nitrogen and boron. Boron nitride is generated at a temperature of approximately 1500°C or more. However, once boron nitride is generated, it doesn't dissolves but that it is under pressure at 3000°C, and thus it becomes the cause of generating dislocation. Namely, it is considered that, when such a boron nitride adheres to a single crystal during growth, dislocation is generated in the growing single crystal.

In particular, in growth of a boron-doped single crystal with low resistivity, concentration of boron in a melt is higher than that in growth of a single crystal with normal resistivity. Therefore, it is considered that boron nitride is easily generated not only in the case of further doping with nitrogen, but also in the case that boron reacts with nitride included in a quartz crucible or generated due to nitrogen in an atmosphere, or nitrogen slightly incorporated in an apparatus for growing a crystal through mechanical leak.

Moreover, the present inventors considered that, when boron nitride is generated in a melt and dislocation is generated, it is very unlikely that the boron nitride is dissolved by remelting, as in a conventional way, the crystal in which dislocation was generated, and it is very likely that boron nitride floats in a melt and adheres again to a growing crystal while the crystal is grown again.

Then, the present inventors considered that melting point of silicon was approximately 1420°C, softening point of a quartz crucible was approximately 1750°C, and although the temperatures of the silicon melt and the crucible were kept between these temperatures during growth, it was important to keep temperatures of a crucible and a melt as low as possible in order to inhibit generation of boron nitride. That is, because generation temperature of boron nitride is approximately 1500°C or more, by controlling the highest temperature of a crucible to be less than 1500°C, temperature of a silicon melt in the crucible is also low and generation of boron nitride can be inhibited.

However, the larger a diameter of crystal becomes, the larger a size of crucible to be used becomes. Since a heater power also becomes larger in order to grow the crystal with keeping molten state all over the melt, a temperature of the crucible increases. Therefore, there are some cases that it is difficult to grow a single crystal with controlling the highest temperature of a crucible to be less than 1500°C.

Then, the present inventors performed investigations and studies. Consequently, it has been found that, in the case of growing a single crystal doped with boron, if the single crystal is grown with controlling the highest temperature of a crucible to be 1600°C or less, reaction of boron and nitrogen is inhibited, frequency of generating dislocation due to boron nitride is considerably decreased, and as a result, productivity can be improved and cost can be lowered. Thus, the present invention has been accomplished.

Hereinafter, according to the present invention, the cases of producing a silicon single crystal doped with boron as dopant at high concentration, and a silicon single crystal doped with boron and nitrogen as dopant will be explained by referring to the appended drawings.

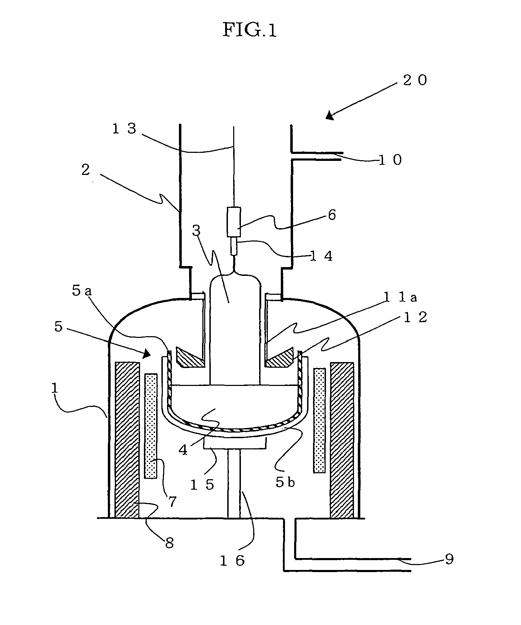

Fig. 1 is a schematic view showing an example of an apparatus for producing a single crystal (a pulling apparatus) that can be used in the present invention. The apparatus 20 for producing a single crystal has a main chamber 1 equipped with a crucible 5 for containing material melt 4 therein and a heater 7, and a pulling chamber 2 for accommodating and taking out a single crystal ingot 3 pulled from the material melt 4.

The crucible 5 is composed of an inner quartz crucible 5a and an outer graphite crucible 5b, and it is disposed on a pedestal 15 and can be moved upwardly or downwardly with being rotated via a rotating shaft 16 by crucible control means (not shown) disposed below.

A heater 7 is provided so as to surround the crucible 5, and a heat insulating member 8 is further provided outside the heater 7.

A gas flow-guide cylinder (an auxiliary cooling cylinder) 11a is provided from between the main chamber 1 and the pulling chamber 2 to a melt surface, and further a heat shielding member 12 is provided at the tip of the gas flow-guide cylinder 11a. Moreover, above the main chamber 1, an optical device (not shown) for measuring and monitoring a diameter and a condition of the growing single crystal ingot 3 is provided.

The pulling chamber 2 is constructed to be openable so that an already grown single crystal can be taken out, and above the pulling chamber 2, crystal pulling means (not shown) for pulling the single crystal 3 with being rotated via a wire (or a shaft) 13 is provided.

In order to produce a silicon single crystal doped with boron at high concentration using such an apparatus 20, in addition to polycrystalline material, boron dopant like metal boron element for example, is contained into the crucible 5, or in order to produce a silicon single crystal doped with boron and nitrogen, nitrogen dopant like silicon nitride as well as boron dopant is contained therein.

Amount of the boron dopant to be added may be decided according to desired resistivity of a silicon single crystal because the amount is reflected by boron concentration in a single crystal to be grown, that is, resistivity. Generally, in the case that a single crystal with a low resistivity of 0.1Ω cm or less is grown, boron concentration in a melt becomes high and boron nitride comes to be easily generated even when not doping with nitrogen intentionally.

When growing a single crystal with a resistivity less than 0.001 Ω cm, concentration of boron in a melt becomes extremely high and exceeds the solid solubility limit of boron to silicon, and thus it becomes difficult to be crystallized as a single crystal. Accordingly, it is preferable that boron dopant is doped so as to become the concentration of boron where resistivity of a single crystal to be grown is from 0.001 Ω cm to 0.1 Ω cm.

On the other hand, because amount of nitrogen dopant is also reflected by concentration of nitrogen in a single crystal to be grown, amount of the dopant may be decided in accordance with desired concentration of nitrogen of a silicon single crystal. When concentration of nitrogen in a single crystal is too low, effects on BMD and Grown-in defects aren't sufficiently obtained. Thus it is preferable that concentration of nitrogen is 1 x 10¹⁰ /cm³ or more, which causes sufficient heterogeneous nucleation.

However, when concentration of nitrogen in a melt exceeds the solid solubility limit to silicon, it becomes difficult to be crystallized as a single crystal. Therefore, it is preferable that nitrogen dopant is doped so that the concentration of nitrogen in a single crystal to be grown is 5 x 10¹⁵ /cm³ or less.

When nitrogen is intentionally doped as mentioned above, boron nitride comes to be easily generated almost irrespective of concentration of boron, for example, even in the case of low concentration of boron where resistivity becomes approximately 1000 Ω cm.

After raw material and dopant are charged into the crucible 5 and are heated and melted by the heater 7, a wire 13 is gently reeled out downwardly from above, and a seed crystal 14, which has a form of circular cylinder or rectangular column and is suspended by a holder 6 attached at the end of the wire 13, is contacted with a melt surface (immersed in the melt). Next, after necking is performed in which the seed crystal 14 is pulled carefully upwardly with being rotated and a diameter is gradually thinned, the diameter of the neck portion is enlarged by controlling the pulling rate, temperature and the like to transfer to growth of cone portion of the single crystal ingot 3. Moreover, after a diameter of the cone portion is enlarged to a prescribed diameter, it is transferred to growth of a straight body with a desired diameter by controlling the pulling rate and temperature of the melt again.

Because the material melt 4 is decreased and the melt surface is lowered along with the growth of the single crystal 3, it is controlled that the crucible 5 is elevated so as to maintain the level of the melt surface to be constant, thereby the growing single crystal ingot 3 keeps a prescribed diameter.

Further, during the operation, an argon gas is introduced into the chambers 1 and 2 from a gas inlet 10, and then discharged from a gas outlet 9, thereby the operation is performed under argon atmosphere.

When a single crystal is grown as mentioned above, there is a case that dislocation is generated in the growing single crystal. When such a dislocation is generated, an operation in which the grown single crystal is melted again and a single crystal is grown again from the same material melt is conventionally repeated. However, according to the investigations of the present inventors, it has been found that, when a P-type single crystal with a low resistivity is particularly grown by CZ method, boron nitride is easily generated in a melt even in the case of not doping with nitrogen intentionally, and adhesion of the boron nitride to the crystal causes generation of dislocation. Since once generated boron nitride (BN) is difficult to dissolve, it is very likely to generate dislocation again even if remelting and regrowing is repeated again and again.

Then, in the present invention, when a single crystal doped with boron is grown as mentioned above, in order to inhibit formation of boron nitride, the single crystal is grown with the highest temperature of a crucible being controlled to be 1600°C or less. As mentioned above, boron nitride is generated when a temperature of a material melt is approximately 1500°C or more. However, when the highest temperature of a crucible is controlled to be 1600°C or less to perform growth, a temperature of a material melt is kept low, and thus generation of boron nitride can be effectively inhibited.

However, if the highest temperature of a crucible is lowered to around the melting point of silicon (1420°C), there is a possibility that it becomes difficult to grow a single crystal with maintaining molten state of entire material. For this reason, although it depends on a size of a crucible to be used and the like, it is preferable that the highest temperature of the crucible is controlled to be from 1450°C to 1600°C, in particular, from 1480°C to 1550°C.

As for control of a temperature of a crucible, for example, the highest temperature can be controlled to be 1600°C or less by adjusting a furnace structure (hot zone structure) such as position of a heat shielding member, height of a heat insulating member and so on.

In the pulling apparatus 20 shown in Fig.1, the distance from a melt surface to the auxiliary cooling cylinder (gas flow-guide cylinder) 11a extends 2.5 times as long as that of the apparatus 30 shown in Fig.4. Generally, when a single crystal is grown, heater power is set so that a temperature in the vicinity of solid-liquid interface between a melt surface and a single crystal becomes a desired value. However, when a heat insulating member 8 around the heater 7 is relatively low as apparatuses shown in Figs.1 and 4, radiation becomes larger, and the crucible 5 and the melt 4 are overheated by the heater 7. However, when the distance between the auxiliary cooling cylinder 11a (heat shielding member 12) and the melt surface is enlarged as the apparatus 20 shown in Fig.1, cooling effect on the crucible 5 and the melt 4 is increased, and thus the temperature of the crucible 5 (the quartz crucible 5a) can be maintained to be 1600°C or less.

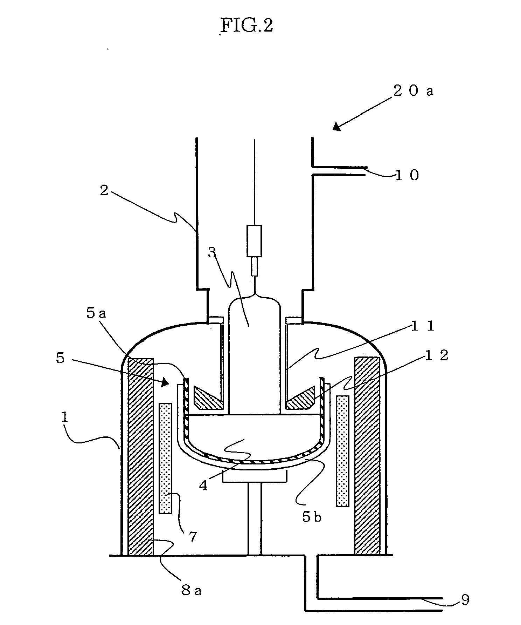

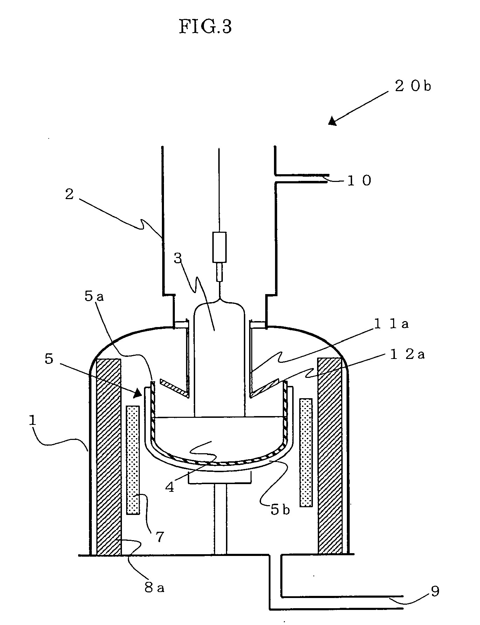

Furthermore, in the apparatus 20a shown in Fig.2, the heat insulating member 8a surrounding the heater 7 is higher than that of the apparatus 30 shown in Fig.4, and thus radiation becomes smaller. In addition, the apparatus 20b shown in Fig.3 adopts a heat shielding member 12a with a thin thickness as well as the auxiliary cooling cylinder 11a shown in Fig.1 and the heat insulating member 8a shown in Fig.2. Because overheat of the crucible 5 by the heater 7 is prevented and cooling effect is increased also in these apparatuses 20a and 20b, the temperature of the crucible 5 (the quartz crucible 5a) can be kept lower, that is, at 1600°C or less.

When a single crystal is practically grown using these apparatuses 20, 20a and 20b, for example, various conditions (heater power, distance between the auxiliary cooling cylinder and the melt surface, length of the heat insulating member, form of the heat shielding member, and the like) may be controlled according to calculation by computer simulation beforehand so that the highest temperature of the crucible is 1600°C or less. Alternatively, it is possible that the temperature of the crucible is really measured by using a thermocouple and the like, and a furnace structure is controlled so that the highest temperature of the crucible is 1600°C or less.

In addition, an apparatus that controls the highest temperature of a crucible to be 1600°C or less is not limited to the apparatuses 20, 20a and 20b as shown in Figs.1-3. It is also possible to use, for example, as disclosed in Japanese Patent Laid-open (Kokai) No. 9-227276, an pulling apparatus that can control the highest temperature of a crucible to be 1600°C or less by setting an auxiliary heater or the like above the crucible to prevent deterioration of the crucible.

Furthermore, a size of a single crystal grown according to the present invention is not particularly limited. However, when a silicon single crystal with a large diameter of 200mm or more, particularly 300mm is grown, it is often the case that the growth is performed by MCZ method by using an apparatus equipped with a device for applying a magnetic field outside of the main chamber 1. At this time, if a magnetic field is applied with the central magnetic field intensity of 300 gauss or more, an effect of suppressing a convection of a melt is increased. Thus a temperature of the melt becomes high and boron nitride is easily generated. However, if the growth is performed with controlling the highest temperature of a crucible to be 1600°C or less, formation of boron nitride can be inhibited. Accordingly, a single crystal with large diameter and high gettering ability can be produced by MCZ method at high productivity.

Then a wafer with low resistivity, which is obtained by processing the silicon single crystal produced as above via the steps of slicing, chamfering, lapping, etching, polishing, and the like, has an extremely excellent gettering ability because its resistivity is low, and thus it can be advantageously used as a substrate for an epitaxial wafer.

Hereinafter, the present invention will be explained in reference to examples and a comparative example.

### <Example 1>

By using the apparatus 20 for producing a single crystal (a diameter of a crucible : 800mm) of which scheme is shown in Fig.1, a P-type (boron-doped) silicon single crystal with a diameter of 12 inches (300mm) was grown by Czochralski method (CZ method).

In the step of melting, 320kg of polycrystalline silicon material was charged into the crucible, at the same time metal boron element for controlling resistivity was added. The amount of the boron was adjusted so that the resistivity of the single crystal to be grown was in the range of 0.005 - 0.01 Ω cm.

Moreover, the distance between an auxiliary cooling cylinder and a melt surface was set to be 75mm.

In the step of growing a crystal, horizontal magnetic field in which central magnetic field intensity was 3500G was applied and a crystal in which a length of the straight body was approximately 120cm was grown.

The highest temperature of the crucible calculated by FEMAG (the global heat transfer analysis software: F. Dupret, P. Nicodeme, Y. Ryckmans, P. Wouters, and M.J. Crochet, Int. J. Heat Mass Transfer, 33, 1849 (1990)) under above conditions was 1543°C.

In the case that dislocation was generated in a crystal during growth, the crystal was melted again and growth is performed again, and until a crystal that can be used as a product was obtained, remelting and regrowing were repeated.

The number of generation of dislocation in this furnace structure until a single crystal as a product was obtained was approximately 1/5 of that in the following Comparative example.

### <Comparative example>

A crystal was grown under the same conditions as Example 1, except that the furnace structure of which scheme was shown in Fig.4 was used, and the distance between the auxiliary cooling cylinder and the melt surface was set to be 30mm. At this time, the highest temperature of the crucible calculated by FEMAG was 1627°C.

In this apparatus, generation of dislocation frequently happened as in the past until a crystal as a product was obtained.

### <Example 2>

A single crystal was grown under the same conditions as Example 1, except that the apparatus of which scheme was shown in Fig.2 was used, the distance between the auxiliary cooling cylinder and the melt surface was set to be 30mm, and the heat insulating member was higher by 20cm. In this apparatus, the heat insulating member was longer and the highest temperature of the crucible calculated by FEMAG was 1597°C.

The number of generation of dislocation in this apparatus until a single crystal as a product was obtained was approximately 1/2 of that in the above Comparative example.

### <Example 3>

A single crystal was grown under the same conditions as Example 1, except that the apparatus of which scheme was shown in Fig.3 was used, a thickness of the heat shielding member was thin, and the heat insulating member was higher by 20cm. In this apparatus, the highest temperature of the crucible calculated by FEMAG was 1563°C.

The number of generation of dislocation in this apparatus until a single crystal was obtained was approximately 1/5 of that in Comparative example. It was slightly more than Example 1.

### <Comparison of productivity>

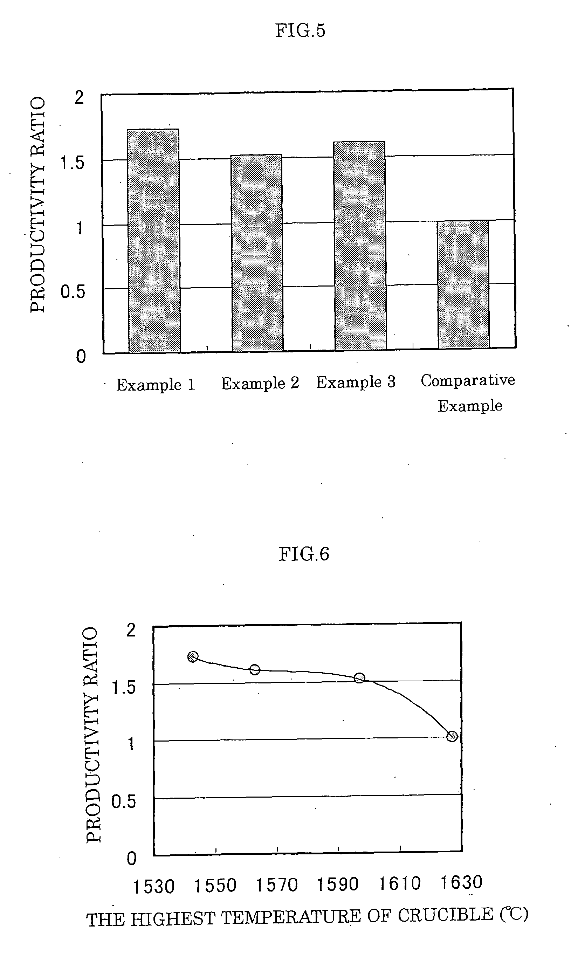

Productivities in above Examples and Comparative example are compared in Fig.5. Furthermore, productivity ratio is plotted to the highest temperature of the crucible in Fig.6.

As shown in Fig.5, productivity in Example 1 was 1.73 times as large as that in Comparative example, Example 2 was 1.53 times and Example 3 was 1.61 times. All of Examples were good result.

Moreover, as seen in Fig.6, productivity was clearly lower in the case that the highest temperature of the crucible is close to 1630°C (Comparative example), than the case that the temperature is controlled at 1600°C or less (Examples 1-3).

The present invention is not limited to the embodiments described above. The above-described embodiments are mere examples, and those having substantially the same structure as technical ideas described in the appended claims and providing the similar functions and advantages are included in the scope of the present invention.

## Claims

1. A method of producing a single crystal according to Czochralski method comprising the steps of, charging polycrystalline material into a crucible, heating and melting the polycrystalline material by a heater disposed so as to surround the crucible, immersing a seed crystal into the material melt and then pulling the seed crystal to grow a single crystal, wherein in the case of growing a single crystal of which resistivity is controlled by doping with boron, the highest temperature of the crucible is controlled to be 1600°C or less to grow the single crystal.

2. The method of producing a single crystal according to Claim 1, wherein the single crystal doped with boron is grown so that the resistivity of the single crystal to be grown is 0.1 Ω cm or less.

3. The method of producing a single crystal according to Claim 1 or Claim 2, wherein the single crystal doped with boron is grown so that the resistivity of the single crystal to be grown is 0.001 Ω cm or more.

4. The method of producing a single crystal according to any one of Claims 1 - 3, wherein the single crystal doped with nitrogen is grown so that concentration of nitrogen in the single crystal to be grown is from 1 x 10¹⁰ /cm³ to 5 x 10¹⁵ /cm³.

5. The method of producing a single crystal according to any one of Claims 1 - 4, wherein a silicon single crystal is grown as the single crystal.

6. The method of producing a single crystal according to any one of Claims 1 - 5, wherein in the case of growing the single crystal, a magnetic field of at least 300 gauss or more is applied to the material melt to grow the single crystal.

7. The method of producing a single crystal according to any one of Claims 1 - 6, wherein a single crystal with a diameter of 200mm or more is grown as the single crystal.
